# EUROPEAN PATENT APPLICATION

(11) **EP 4 238 698 A1**
(43) Date of publication of application: **06.09.2023**
(21) Application number: 21885652.4
(22) Date of filing: 19.08.2021
(51) Int. Cl.: B24B 37/013, B24B 49/10, B24B 49/12, H01L 21/304

(54) **POLISHING APPARATUS AND POLISHING METHOD**

(30) Priority: 02.11.2020 JP 2020183554
(71) Applicant: EBARA CORPORATION, Ota-ku, Tokyo 144-8510 (JP)
(72) Inventor: YAZAWA, Akihiro, Tokyo 144-8510 (JP); MIYASAWA, Yasuyuki, Tokyo 144-8510 (JP)
(74) Representative: Schmidbauer, Andreas Konrad
(86) International application number: PCT/JP2021/030352
(87) International publication number: WO 2022/091532

(57) **Abstract**

To provide a technique that allows accurately measuring a polishing state of a substrate.

A polishing apparatus 100 includes: a sensor head 40 that includes a projector configured to project incident light, a condenser configured to condense the incident light projected from the projector and cause the incident light to be incident on a substrate Wf, and an optical receiver configured to receive reflected light reflected by the substrate; a displacement mechanism 60 configured to relatively displace the condenser with respect to the substrate to change a distance between the condenser and the substrate; an abrade amount measurement device 70 configured to measure an abrade amount of a polishing pad 90; and a control device 80. The control device is configured to measure a polishing state of the substrate based on a light amount parameter of the reflected light received by the optical receiver and control the displacement mechanism based on the abrade amount of the polishing pad measured by the abrade amount measurement device such that the distance between the condenser and the substrate is maintained at a preliminarily set reference distance.

## Description

### TECHNICAL FIELD

The present invention relates to a polishing apparatus and a polishing method. This application claims priority from Japanese Patent Application No. 2020-183554 filed on November 2, 2020. The entire disclosure including the descriptions, the claims, the drawings, and the abstracts in Japanese Patent Application No. 2020-183554 is herein incorporated by reference.

### BACKGROUND ART

Conventionally, as a polishing apparatus of a substrate, there has been known a polishing apparatus that includes a substrate holding member that holds the substrate and a polishing table that holds a polishing pad and polishes the substrate while pressing the substrate against the polishing pad (for example, see PTLs 1, 2, and 3). Conventionally, as such a polishing apparatus, there has been known a polishing apparatus that allows optically measuring a polishing state of a substrate (for example, see PTLs 1 and 2). Specifically, the polishing apparatus includes a sensor head that includes a projector that projects incident light, a condenser that condenses incident light projected from the projector and projects it to a substrate, and an optical receiver that receives reflected light reflected by the substrate. The polishing apparatus measures a polishing state of the substrate based on a parameter related to a light amount of the reflected light received by the optical receiver (referred to as a light amount parameter).

### CITATION LIST

### PATENT LITERATURE

PTL 1: Japanese Unexamined Patent Application Publication No. 10-229060
PTL 2: Japanese Unexamined Patent Application Publication No. 2001-235311
PTL 3: Japanese Unexamined Patent Application Publication No. 2020-19115

### SUMMARY OF INVENTION

### TECHNICAL PROBLEM

When the polishing pad abrades in association with use of the polishing apparatus in the conventional polishing apparatus as described above, a distance between the condenser and the substrate becomes possibly closer than a reference distance set in advance. When the distance between the condenser and the substrate thus becomes smaller than the reference distance, "defocus" in which a focal point of the incident light condensed by the condenser does not match a position originally set possibly occurs. When the defocus occurs, accurately measuring the polishing state of the substrate possibly becomes difficult.

The present invention has been made in view of the above-described things, and one object is to provide a technique that allows accurately measuring a polishing state of a substrate.

### SOLUTION TO PROBLEM

### (Aspect 1)

To achieve the above-described object, a polishing apparatus according to one aspect of the present invention includes a substrate holding member and a polishing table. The substrate holding member is configured to hold a substrate. The polishing table is configured to hold a polishing pad. The polishing apparatus is configured to polish the substrate while pressing the substrate against the polishing pad. The polishing apparatus includes a sensor head, a displacement mechanism, an abrade amount measurement device, and a control device. The sensor head includes a projector, a condenser, and an optical receiver. The projector is configured to project incident light. The condenser is configured to condense the incident light projected from the projector and cause the incident light to be incident on the substrate. The optical receiver is configured to receive reflected light reflected by the substrate. The displacement mechanism is configured to relatively displace the condenser with respect to the substrate to change a distance between the condenser and the substrate. The abrade amount measurement device is configured to measure an abrade amount of the polishing pad. The control device is configured to measure a polishing state of the substrate based on a light amount parameter. The light amount parameter is a parameter related to a light amount of the reflected light received by the optical receiver. The control device is configured to control the displacement mechanism based on the abrade amount of the polishing pad measured by the abrade amount measurement device such that the distance between the condenser and the substrate is maintained at a preliminarily set reference distance.

According to the aspect, even when the polishing pad abrades, the distance between the condenser and the substrate can be maintained at the reference distance, and therefore defocus can be suppressed. This allows accurately measuring the polishing state of the substrate.

### (Aspect 2)

In the above-described aspect 1, the control device may be configured to measure a polishing ending point of the substrate as the polishing state of the substrate. According to the aspect, the polishing ending point of the substrate can be accurately measured.

### (Aspect 3)

In the above-described aspect 1 or aspect 2, the control device may be configured to further calculate a distance between the condenser and the substrate such that the light amount parameter becomes larger than a predetermined value by performing machine learning based on a data group associating the light amount parameter with the distance between the condenser and the substrate, and use the calculated distance as the reference distance. According to the aspect, the distance between the condenser and the substrate can be the distance such that the light amount parameter becomes larger than the predetermined value without manpower.

### (Aspect 4)

In one aspect of any of the above-described aspects 1 to 3, the control device may be configured to further predict a change in light amount parameter as a change in the light amount parameter in association with a lapse of a polishing time corresponding the process condition by performing machine learning based on a data group associating a process condition as a condition related to a polishing rate of the substrate by the polishing apparatus with the light amount parameter. The control device may be configured to calculate an abnormal range of the change in light amount parameter equivalent to a case where abnormality occurs in the polishing apparatus based on the predicted change in light amount parameter and cause a storage medium to store the calculated abnormal range of the change in light amount parameter.

### (Aspect 5)

In the above-described aspect 4, the control device may be configured to further determine whether abnormality occurs in the polishing apparatus based on the abnormal range of the change in light amount parameter stored in the storage medium and an actually measured value of the change in light amount parameter during polishing the substrate by the polishing apparatus. According to the aspect, whether abnormality occurs in the polishing apparatus can be determined.

### (Aspect 6)

In any one aspect among the above-described aspects 1 to 5, the control device may be configured to further determine whether substrate slip-out in which the substrate comes off from the substrate holding member occurs based on whether the light amount parameter is smaller than a threshold. According to the aspect, whether the substrate slip-out occurs can be determined.

### (Aspect 7)

In one aspect of any of the above-described aspects 1 to 6, the sensor head may be disposed on the polishing table. The sensor head may be configured to rotate together with the polishing table during polishing the substrate by the polishing apparatus. The control device may be configured such that when a relative position between the substrate and the sensor head is at a position where the incident light is incident on the surface to be polished during polishing the substrate by the polishing apparatus, the control device may further control projection timing of the projector such that the projector projects the incident light. According to the aspect, a useless energy consumption, such as while incident light being not incident on the substrate, incident light being projected, can be suppressed.

### (Aspect 8)

In the above-described aspect 7, a light transmitting member configured to transmit the incident light condensed by the condenser and the reflected light reflected by the substrate may be disposed on a part of the polishing pad. According to the aspect, even when optical transmission performance of the polishing pad is low, the polishing state of the substrate can be optically measured.

### (Aspect 9)

To achieve the above-described object, a polishing method according to one aspect of the present invention includes: a step of condensing incident light projected from a projector during polishing a substrate by a polishing apparatus by a condenser to cause the incident light to be incident on the substrate, receiving reflected light reflected by the substrate by an optical receiver, and measuring a polishing state of the substrate based on a light amount parameter as a parameter related to a light amount of the reflected light received by the optical receiver; and a step of relatively displacing the condenser with respect to the substrate based on an abrade amount of the polishing pad against which the substrate is pressed such that a distance between the condenser and the substrate is maintained at a preliminarily set reference distance during polishing the substrate by the polishing apparatus.

According to the aspect, even when the polishing pad abrades, the distance between the condenser and the substrate can be maintained at the reference distance, and therefore defocus can be suppressed. This allows accurately measuring the polishing state of the substrate.

### BRIEF DESCRIPTION OF DRAWINGS

Fig. 1A is a configuration diagram schematically illustrating a main configuration of a polishing apparatus according to Embodiment 1.
Fig. 1B is a schematic plan view of a polishing machine main body according to Embodiment 1.
Fig. 2 is a cross-sectional view schematically illustrating an enlarged peripheral configuration of a substrate holding member of the polishing apparatus according to Embodiment 1.
Fig. 3 is a schematic diagram for describing configurations of a sensor head and a light source/spectral module according to Embodiment 1.
Fig. 4 is a schematic diagram for describing a configuration of a displacement mechanism according to Embodiment 1.
Fig. 5 is a flowchart depicting exemplary control of a sensor and the displacement mechanism by a control device according to Embodiment 1.
Fig. 6 is one example of a flowchart of reference distance setting control according to Embodiment 2.
Fig. 7 is one example of a flowchart of abnormality determination control according to Embodiment 3.
Fig. 8A is a schematic diagram for describing a control process according to Step S31 of Embodiment 3.
Fig. 8B is a schematic diagram for describing a control process according to Step S31 of Embodiment 3.
Fig. 9 is one example of a flowchart of substrate slip-out control according to Embodiment 4.

### DESCRIPTION OF EMBODIMENTS

The following will describe respective embodiments of the present invention with reference to the drawings. Note that in the following respective Embodiments, the same reference numerals are given to identical or corresponding configurations and the description is appropriately omitted in some cases. Additionally, the drawings of the application are schematically illustrated for ease of understanding of the features of the embodiments, and dimensional proportions of respective components and the like are not always same as those of the actual ones.

### (Embodiment 1)

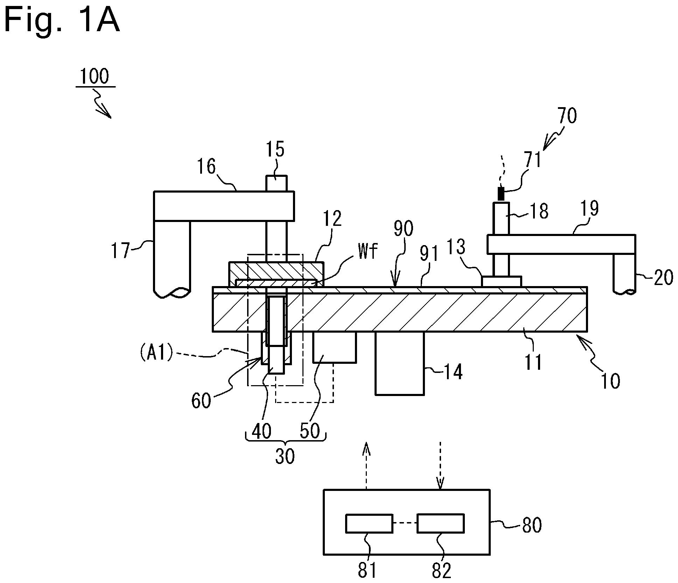

Fig. 1A is a configuration diagram schematically illustrating a main configuration of a polishing apparatus 100 according to Embodiment 1 of the present invention. The polishing apparatus 100 according to this embodiment is a polishing apparatus that allows chemical mechanical polishing (Chemical Mechanical Polishing: CMP). Specifically, the polishing apparatus 100 illustrated in Fig. 1A as an example mainly includes a polishing machine main body 10, a sensor 30, a displacement mechanism 60, an abrade amount measurement device 70, and a control device 80. Note that in Fig. 1A, the front view of the polishing machine main body 10 is schematically illustrated. Additionally, the configuration of a part of the polishing machine main body 10 is schematically illustrated in the cross-sectional view.

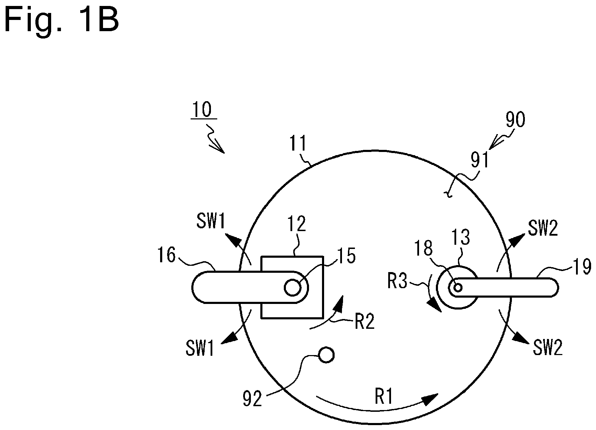

Fig. 1B is a schematic plan view (top view) of the polishing machine main body 10. Note that a polishing table 11 described later of the polishing machine main body 10 in Fig. 1B is illustrated in a state of being rotated by a predetermined angle with respect to the polishing table 11 in Fig. 1A. Therefore, Fig. 1B is drawn such that a light transmitting member 92 described later can be visually perceived from the upper side. With reference to Fig. 1A and Fig. 1B, the polishing machine main body 10 mainly includes the polishing table 11, a substrate holding member 12, and a dresser 13.

The polishing table 11 is configured to hold and rotate a polishing pad 90. Specifically, the polishing table 11 according to this embodiment is configured by a disk-shaped member, and the polishing pad 90 is bonded to the upper surface. The upper surface (front surface) of the polishing pad 90 is equivalent to a polishing surface 91. Additionally, the polishing table 11 is connected to a table rotation shaft 14. Rotatably driving the table rotation shaft 14 by a driving mechanism (such as a rotation motor) rotates the polishing table 11. During polishing, a surface to be polished Wfc described later of a substrate Wf is pressed against the polishing surface 91. The control device 80 described later controls the rotation operation of the polishing table 11. "R1" illustrated in Fig. 1B is an example of the rotation direction of the polishing table 11.

The specific type of the polishing pad 90 is not particularly limited, and various polishing pads, such as a hard foam type polishing pad, a non-woven fabric type polishing pad, or a suede type polishing pad, can be used. The polishing pad 90 is appropriately set according to the type of the substrate Wf.

The substrate holding member 12 is a member for holding the substrate Wf. The substrate holding member 12 is configured to rotate the surface to be polished Wfc of the substrate Wf while pressing the surface to be polished Wfc against the polishing pad 90. Specifically, the substrate holding member 12 is connected to a substrate rotation shaft 15. Rotatably driving the substrate rotation shaft 15 by a driving mechanism (such as the rotation motor) rotates the substrate holding member 12. Note that "R2" illustrated in Fig. 1B is an example of the rotation direction of the substrate holding member 12. To the upper end of the substrate rotation shaft 15, a pressing cylinder (not illustrated) for pressing the substrate rotation shaft 15 downward is connected. When the substrate rotation shaft 15 is pressed downward by the pressing cylinder, the substrate Wf held onto the substrate holding member 12 is pressed to the polishing pad 90.

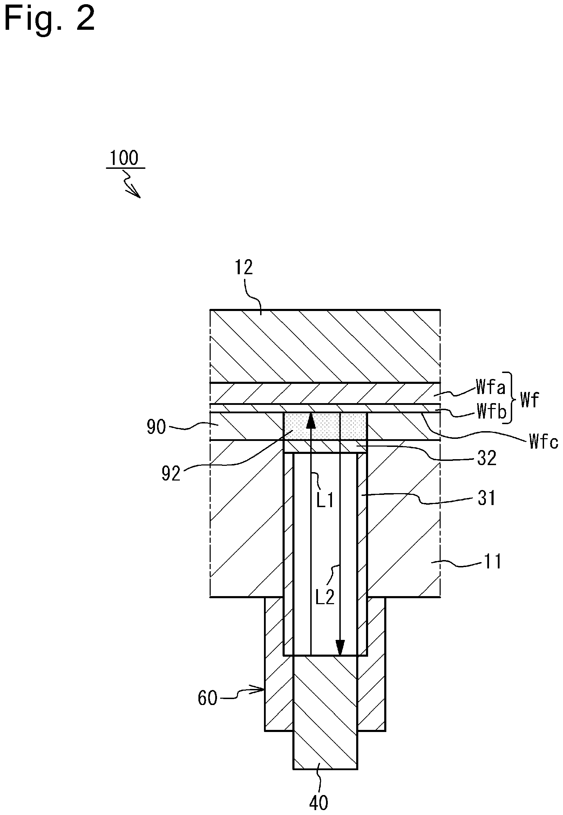

Fig. 2 is a cross-sectional view schematically illustrating an enlarged peripheral configuration of the substrate holding member 12 of the polishing apparatus 100, and specifically schematically illustrates the enlarged configuration in the vicinity of A1 in Fig. 1A in the cross-sectional view. As illustrated in Fig. 2, the substrate Wf according to this embodiment includes a substrate core Wfa and a film Wfb formed on the surface of the substrate core Wfa. The surface (lower surface) of the film Wfb is equivalent to the surface to be polished Wfc. Although the material of the substrate core Wfa is not specifically limited, a glass-based material is used as an example in this embodiment. The material of the film Wfb is not specifically limited, and an inorganic compound, an organic compound, or the like can be used. In this embodiment, a wiring pattern structure is included inside the film Wfb. That is, an example of the substrate Wf according to this embodiment is a printed-circuit board.

With reference to Fig. 1A and Fig. 1B again, the substrate holding member 12 according to this embodiment is configured to swing with respect to the polishing pad 90. Specifically, the substrate rotation shaft 15 of the substrate holding member 12 is connected to a substrate swing shaft 17 via a substrate swing arm 16. Swingably driving the substrate swing shaft 17 by the driving mechanism swings the substrate swing arm 16 so as to draw an arc around the substrate swing shaft 17 (that is, turns clockwise and counterclockwise), and as a result, the substrate holding member 12 similarly swings. Note that the substrate holding member 12 is a member generally also known as a "top ring," a "polishing head," and the like. The control device 80 controls the rotation operation and the swing operation of the substrate holding member 12. Note that "SW1" illustrated in Fig. 1B is one example of the swinging direction of the substrate holding member 12.

The dresser 13 is a member for dressing the polishing surface 91 of the polishing pad 90. An abrasive grain (such as a diamond) is disposed on the lower surface of the dresser 13. The dresser 13 is connected to a dresser rotation shaft 18. Rotatably driving the dresser rotation shaft 18 by the driving mechanism (such as the rotation motor) rotates the dresser 13. Additionally, to the upper end of the dresser rotation shaft 18, a pressing cylinder (not illustrated) for pressing the dresser rotation shaft 18 downward is connected. By the dresser rotation shaft 18 being pressed downward by the pressing cylinder, the dresser 13 is pressed to the polishing pad 90. Note that "R3" illustrated in Fig. 1B is one example of the rotation direction of the dresser 13.

Additionally, the dresser 13 according to this embodiment is configured to swing with respect to the polishing pad 90. Specifically, the dresser rotation shaft 18 of the dresser 13 is connected to a dresser swing shaft 20 via a dresser swing arm 19. Swingably driving the dresser swing shaft 20 by a driving mechanism (such as a swing motor) swings the dresser swing arm 19 around the dresser swing shaft 20, and as a result, the dresser 13 similarly swings. The control device 80 controls the rotation operation and the swing operation of the dresser 13. Note that "SW2" illustrated in Fig. 1B is one example of the swinging direction of the dresser 13.

During dressing by the dresser 13, pure water is supplied to the polishing surface 91 of the polishing pad 90 and the polishing table 11 rotates. In the state, by the dresser 13 rotating while swinging, the polishing surface 91 is dressed. Thus performing dressing allows dressing the polishing surface 91 of the polishing pad 90 and recovering the polishing rate of the substrate Wf by the polishing apparatus 100.

The polishing apparatus 100 includes a slurry supply mechanism (not illustrated) for supplying the polishing surface 91 of the polishing pad 90 with slurry (polishing slurry). As the slurry, for example, a solution containing an abrasive grain, such as silicon oxide, aluminum oxide, and cerium oxide, can be used. The specific kind of the slurry only needs to be appropriately set according to the kind of the film Wfb. Note that the slurry may be supplied from the upper side of the polishing pad 90, may be supplied from the lower side, or may be supplied from both the upper side and the lower side. In the polishing apparatus 100, each of the polishing table 11 and the substrate holding member 12 rotates in the presence of the slurry to polish the surface to be polished Wfc (the film Wfb) of the substrate Wf.

The control device 80 integrally controls the operation of the polishing apparatus 100. Specifically, the control device 80 according to this embodiment includes a computer. The computer (specifically, a microcomputer) includes a Central Processing Unit (CPU) 81 as a processor, a storage 82 as a non-transitory storage medium, and the like. The computer is electrically connected to a controlled unit of the polishing apparatus 100. The CPU 81 as the processor of the control device 80 operates based on a command of a program stored in the storage 82 to control the operation of the polishing machine main body 10. Additionally, the control device 80 according to this embodiment also controls the operation of the sensor 30 and the displacement mechanism 60 described later. The control device 80 that controls the sensor 30, the displacement mechanism 60, and the abrade amount measurement device 70 has a function as a "polishing state measurement system."

Note that in this embodiment, while one control device 80 has a function as the control device of the polishing machine main body 10, the sensor 30, and the displacement mechanism 60, the configuration is not limited to this. For example, the polishing apparatus 100 may individually include a control device for the polishing machine main body 10, a control device for the sensor 30, and a control device for the displacement mechanism 60 (that is, the plurality of control devices may control the controlled units).

Subsequently, the sensor 30 will be described. With reference to Fig. 1A, the sensor 30 includes a sensor head 40 and a light source/spectral module 50. The sensor head 40 and the light source/spectral module 50 according to this embodiment are disposed on the polishing table 11 as one example. The sensor head 40 and the light source/spectral module 50 rotate together with the polishing table 11 during polishing the substrate Wf by the polishing apparatus 100.

As illustrated in Fig. 2 and Fig. 1B, on a part of the polishing pad 90 according to this embodiment, the light transmitting member 92 through which incident light L1 and reflected light L2 described later are passable is disposed. In this embodiment, the light transmitting member 92 is configured by a material having light transparency, specifically a window member (namely, a translucent window member) made of a transparent material, such as transparent plastic and a transparent glass. The incident light L1 condensed by a condenser 42 described later passes through the light transmitting member 92 and then is incident on the substrate Wf (specifically, the surface to be polished Wfc). Additionally, the reflected light L2 reflected by the substrate Wf passes through the light transmitting member 92 and then is received by an optical receiver 43 described later.

As in this embodiment, by disposing the light transmitting member 92 on a part of the polishing pad 90, even when the optical transmission performance of the polishing pad 90 is low, the polishing state of the substrate Wf can be optically measured.

As illustrated in Fig. 2, the sensor head 40 according to this embodiment is connected to the polishing table 11 via a tubular tool 31. The tool 31 is connected to the polishing table 11 such that the incident light L1 and the reflected light L2 described later can pass inside the tool 31. Specifically, the tool 31 according to this embodiment is fitted to a tubular hole disposed in the polishing table 11 as one example. Additionally, the top end surface of the tool 31 according to this embodiment is connected to a lower surface of a glass plate 32 disposed on the lower surface of the light transmitting member 92. The glass plate 32 effectively suppresses entrance of a foreign matter, such as slurry, into the inside the tool 31 (inside the tube). Note that the tool 31 is preferably in close contact with the lower surface of the glass plate 32 so as not to form a gap between the tool 31 and the glass plate 32.

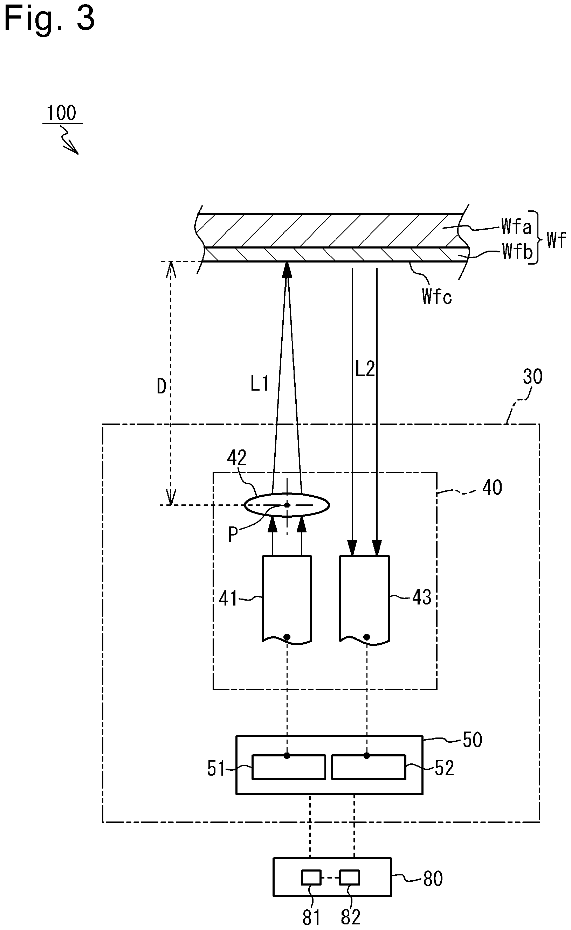

Fig. 3 is a schematic diagram for describing the configurations of the sensor head 40 and the light source/spectral module 50. Note that Fig. 3 omits the illustration of the displacement mechanism 60 described later. The sensor head 40 includes a projector 41, the condenser 42, and the optical receiver 43. The light source/spectral module 50 includes a light source 51 and a spectroscope 52.

The type of the light source 51 is not specifically limited and, for example, a laser light emitter and a halogen lamp can be used. The laser light emitter is used as one example of the light source 51 in this embodiment. The control device 80 controls the operation of the light source 51.

The sensor head 40 internally houses the projector 41, the condenser 42, and the optical receiver 43. The projector 41 is a device that projects the incident light L1 to a predetermined direction. Specifically, the projector 41 according to this embodiment projects the incident light L1 toward the direction of the substrate Wf. Additionally, the projector 41 according to this embodiment is configured by an optical fiber. The optical fiber has one end (the end portion on the opposite side of the substrate Wf side) connected to the light source 51. The light emitted from the light source 51 passes through the optical fiber and is projected as the incident light L1.

The condenser 42 is a device that condenses the incident light L1 projected from the projector 41 and causes it to be incident on the substrate Wf (specifically, the surface to be polished Wfc). As long as the function is provided, the specific configuration of the condenser 42 is not specifically limited, and a lens (namely, a condenser lens) is used as one example of the condenser 42 in this embodiment. The lens as the condenser 42 is disposed between the projector 41 and the substrate Wf. Note that although Fig. 3 omits the illustrations of the above-described glass plate 32 and light transmitting member 92, actually, the incident light L1 condensed by the condenser 42 passes through the glass plate 32 and the light transmitting member 92 and then is incident on the substrate Wf.

Additionally, in this embodiment, a distance (D) between the condenser 42 and the substrate Wf is set to a predetermined "reference distance." Note that in this embodiment, the distance (D) between the condenser 42 and the substrate Wf specifically means "the distance between a principal point (P) of the lens as the condenser 42 and the surface to be polished Wfc of the substrate Wf." However, the configuration is not limited to this, and, for example, the distance (D) between the condenser 42 and the substrate Wf may be a distance between another predetermined position in the condenser 42 and another predetermined position in the substrate Wf.

Additionally, in this embodiment, the "reference distance" is set to a value same as a focal point distance of the condenser 42. Thus, in this embodiment, the focal point of the incident light L1 condensed by the condenser 42 matches the surface to be polished Wfc of the substrate Wf.

The optical receiver 43 is a device that receives the reflected light L2 reflected by the substrate Wf. Specifically, the optical receiver 43 according to this embodiment is configured by an optical fiber. The optical fiber has one end (the end portion on the opposite side of the substrate Wf side) connected to the spectroscope 52.

The spectroscope 52 is a device that disperses the reflected light L2 and converts a light amount parameter of the dispersed light (a parameter related to the light amount) into a digital signal. In this embodiment, the light amount or reflectance is used as one example of the light amount parameter. The digital signal converted by the spectroscope 52 is transmitted to the control device 80.

The control device 80 controls the light source 51 to control projection timing of the incident light L1 from the projector 41. Specifically, when the relative position between the substrate Wf and the sensor head 40 is at a position where the incident light L1 is incident on the substrate Wf during polishing by the polishing apparatus 100, the control device 80 according to this embodiment projects the incident light L1 from the projector 41. The details are as follows.

First, the sensor head 40 rotates together with the polishing table 11 and further the substrate holding member 12 also swings. In view of this, when the projector 41 projects the incident light L1 at timing of the sensor head 40 passing through below the substrate Wf held onto the substrate holding member 12, the incident light L1 can be reliably incident on the substrate Wf.

Therefore, in this embodiment, a range of a rotation phase (rad) of the polishing table 11 and a range of a swing phase (rad) of the substrate holding member 12 (they are referred to as "target phase ranges") at which the sensor head 40 passes through below the substrate Wf (that is, the incident light L1 is incident on the substrate Wf) are preliminarily obtained, and they are stored in the storage 82 of the control device 80 in advance. Then, the control device 80 obtains the rotation phase of the polishing table 11 based on a detection result of a sensor (not illustrated) that detects the rotation phase of the polishing table 11, obtains the swing phase of the substrate holding member 12 based on a detection result of a sensor (not illustrated) that detects the swing phase of the substrate holding member 12, and when these obtained rotation phase and swing phase are within the preliminarily set target phase ranges, the light source 51 is caused to emit light to project the incident light L1 from the projector 41. Thus, the control device 80 causes the incident light L1 to be reliably incident on the surface to be polished Wfc of the substrate Wf during polishing by the polishing apparatus 100.

According to the above-described configuration, a useless energy consumption, such as while incident light L1 being not incident on the substrate, incident light L1 being projected, can be suppressed.

The control device 80 measures the polishing state of the substrate Wf based on the reflected light L2 received by the optical receiver 43. Specifically, the control device 80 according to this embodiment measures the polishing state of the substrate Wf based on the light amount parameter related to the light amount of the reflected light L2 (the light amount or the reflectance as one example in this embodiment). Additionally, the control device 80 according to this embodiment measures data regarding a film thickness of the substrate Wf during polishing as one example of the polishing state of the substrate Wf. More specifically, the "polishing ending point" of the substrate Wf during polishing is measured. Note that as the measurement mechanism itself that measures the polishing ending point based on the reflected light L2, for example, the publicly-known techniques as in, for example, PTL 1 and PTL 2 are applicable, and the specific contents are not specifically limited. However, the control device 80 according to this embodiment, for example, measures the polishing ending point by the following measurement mechanism.

The control device 80 according to this embodiment indexes the light amount parameter of the reflected light L2 based on the data transmitted from the spectroscope 52, subsequently performs a noise removal process of a time waveform of the indexed data, and analyzes the waveform after the noise removal process is performed to detect the light amount parameter and feature points (feature points, such as a local maximal value and a local minimal value and a threshold of a differential value). The value that has been detected (detected value) has a correlation relationship with the film thickness. Therefore, the control device 80 calculates the film thickness of the substrate Wf based on the detected value and obtains it, and when the film thickness of the substrate Wf becomes a reference film thickness set in advance, it is determined that the film thickness of the substrate Wf reaches the polishing ending point. Thus, the control device 80 measures the polishing ending point of the substrate Wf. When the control device 80 determines that the film thickness of the substrate Wf reaches the polishing ending point, the control device 80 causes the polishing apparatus 100 to end the polishing.

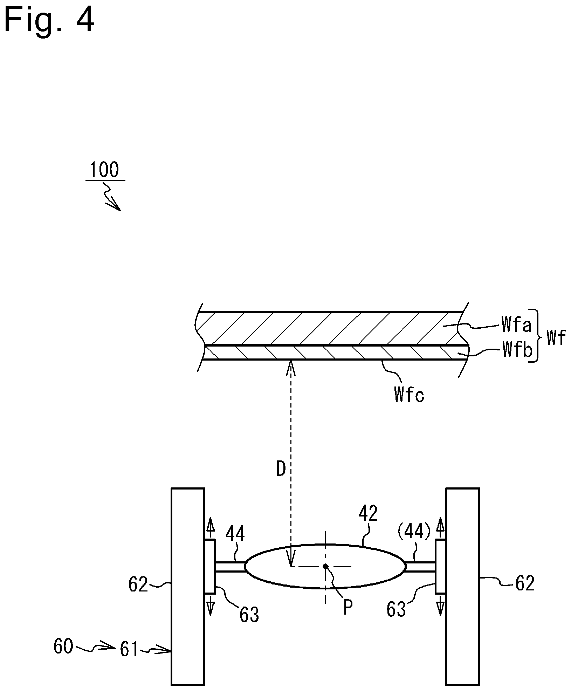

Subsequently, the displacement mechanism 60, the abrade amount measurement device 70, and control of the displacement mechanism 60 by the control device 80 will be described. Fig. 4 is a schematic diagram for describing the configuration of the displacement mechanism 60. The displacement mechanism 60 is a mechanism configured to relatively displace the condenser 42 with respect to the substrate Wf upon receiving the command from the control device 80 to change the distance (D) between the condenser 42 and the substrate Wf. Specifically, the displacement mechanism 60 according to this embodiment displaces the condenser 42 in a vertical direction upon receiving the command from the control device 80 to displace the condenser 42 in the direction of approaching the surface to be polished Wfc of the substrate Wf or the direction of separating from the surface to be polished Wfc.

As long as the function is provided, the specific configuration of the displacement mechanism 60 is not specifically limited, and the publicly-known technique that allows a target member to be vertically displaced is applicable. In this embodiment, a linear motion actuator 61 is used as the specific example of the displacement mechanism 60. The configuration of the linear motion actuator 61 is not specifically limited. In this embodiment, as one example of the linear motion actuator 61, the one that includes a rail 62 that vertically extends and a slider 63 that slides along the rail 62 is used. The slider 63 is connected to a condenser holding member 44 that holds the condenser 42. The slider 63 is vertically displaced to vertically displace the condenser 42.

Note that the configuration of the displacement mechanism 60 is not limited to the one illustrated in Fig. 4 as an example. For example, as the displacement mechanism 60, the other publicly-known mechanisms, such as a piston-cylinder linear motion actuator and a ball screw linear motion actuator, can be used.

Additionally, the displacement mechanism 60 may displace not only the condenser 42 among the sensor head 40, but also displace the projector 41 and the optical receiver 43 together with the condenser 42. Specifically, in this case, the displacement mechanism 60 only needs to displace the sensor head 40 itself, for example.

With reference to Fig. 1A, the abrade amount measurement device 70 is a device that measures an abrade amount (µm) of the polishing pad 90. Specifically, the abrade amount measurement device 70 according to this embodiment includes a displacement sensor 71. The displacement sensor 71 according to this embodiment measures the displacement in the vertical direction of the dresser rotation shaft 18 of the dresser 13 to measure the displacement in the vertical direction of the dresser 13 and measure the abrade amount of the polishing pad 90 based on the measurement result. The detection result of the displacement sensor 71 is transmitted to the control device 80. Note that the abrade amount measurement device 70 according to this embodiment at least measures the abrade amount of the polishing pad 90 during polishing the substrate Wf by the polishing apparatus 100 upon receiving the command of the control device 80. As the abrade amount measurement device 70, the publicly-known technique as described in PTL 3 described above is applicable, and therefore the abrade amount measurement device 70 will not be described in detail any further.

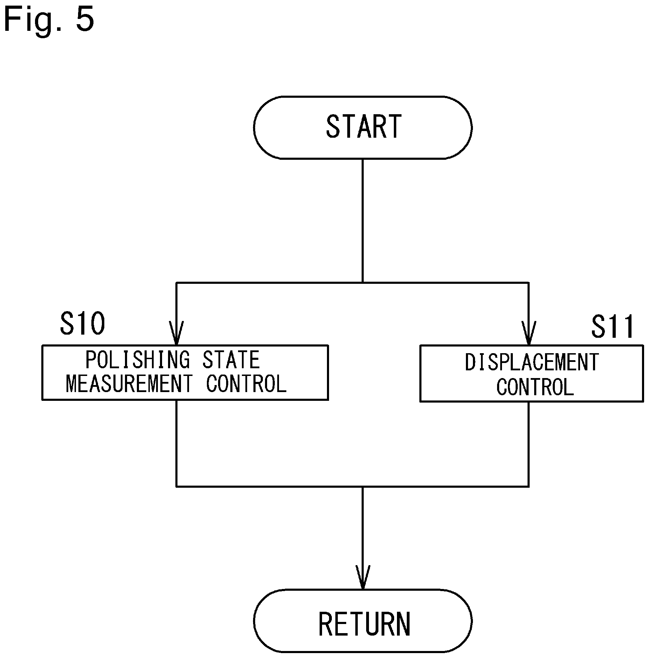

Fig. 5 is a flowchart depicting exemplary control of the sensor 30 and the displacement mechanism 60 by the control device 80 according to this embodiment. The control device 80 measures the polishing state of the substrate Wf based on the light amount parameter of the reflected light L2 received by the optical receiver 43 during polishing the substrate Wf by the polishing apparatus 100 (Step S10: this will be referred to as "polishing state measurement control"). Furthermore, the control device 80 controls the displacement mechanism 60 based on the abrade amount of the polishing pad 90 measured by the abrade amount measurement device 70 such that the distance (D) between the condenser 42 and the substrate Wf is maintained at the preliminarily set reference distance during polishing the substrate Wf by the polishing apparatus 100 (Step S11: this will be referred to as "displacement control"). Note that Step S10 and Step S11 may be simultaneously performed during polishing the substrate Wf. Alternatively, while the same substrate Wf is in the polishing process, Step S10 and Step S11 may be separately (non-simultaneously) performed.

In the displacement control according to Step S11, specifically, the control device 80 controls the displacement mechanism 60 such that the condenser 42 is separated from the substrate Wf by the abrade amount of the polishing pad 90 to maintain the distance between the condenser 42 and the substrate Wf at the reference distance. As described above, in this embodiment, the reference distance is set to the value same as the focal point distance of the condenser 42. The displacement control will be specifically described with a value example as follows.

First, for example, assume that in a state before polishing of the substrate Wf by the polishing apparatus 100 starts, the new polishing pad 90 is held onto the polishing table 11. The distance (D) between the condenser 42 and the substrate Wf in the polishing pad 90 held onto the polishing table 11 is set to the reference distance. Assume that the polishing pad 90 abrades, for example, 10 µm in association with the use of the polishing apparatus 100. Specifically, assume that the polishing pad 90 abrades by 10 µm in association with the progress of polishing the substrate Wf during polishing the substrate Wf by the polishing apparatus 100. In this case, the control device 80 obtains that the abrade amount of the polishing pad 90 is 10 µm based on the detection result of the displacement sensor 71.

Here, provisionally, when the polishing apparatus 100 does not include the displacement mechanism 60, as described above, in the case where the polishing pad 90 abrades by 10 µm, the distance between the substrate Wf and the condenser 42 becomes shorter than the original reference distance by 10 µm. In this case, the above-described "defocus" possibly occurs.

In contrast to this, according to this embodiment, the control device 80 controls the displacement mechanism 60 during polishing the substrate Wf by the polishing apparatus 100 to displace the condenser 42 to the lower side by 10 µm, thus separating the condenser 42 from the substrate Wf by 10 µm. This allows maintaining the distance between the substrate Wf and the condenser 42 at the reference distance originally set (namely, the focal point distance).

As described above, according to the polishing apparatus 100 according to this embodiment, even when the polishing pad 90 abrades, the distance between the condenser 42 and the substrate Wf can be maintained at the reference distance, thus ensuring suppressing defocus. This allows accurately measuring the polishing state of the substrate Wf. Specifically, according to this embodiment, the polishing ending point of the substrate Wf can be accurately measured.

### (Polishing Method)

Note that the polishing method according to this embodiment is achieved by the above-described polishing apparatus 100. Specifically, the polishing method according to this embodiment includes a step of measuring the polishing state of the substrate Wf based on the light amount parameter of the reflected light L2 received by the optical receiver 43 during polishing the substrate Wf by the polishing apparatus 100 (referred to as a "polishing state measuring step") and a step of controlling the displacement mechanism 60 based on the abrade amount of the polishing pad 90 measured by the abrade amount measurement device 70 such that the distance between the condenser 42 and the substrate Wf during polishing the substrate Wf by the polishing apparatus 100 is maintained at the preliminarily set reference distance D (referred to as a "displacement step").

The polishing state measuring step is equivalent to Step S10 and the displacement step is equivalent to Step S11 in Fig. 5. Since the details of the polishing method according to this embodiment overlaps with the above-described description of the polishing apparatus 100, the description will be omitted.

The polishing method according to this embodiment described above also allows suppressing defocus and accurately measuring the polishing state of the substrate Wf.

### (Embodiment 2)

Subsequently, Embodiment 2 of the present invention will be described. The polishing apparatus 100 according to this embodiment differs from Embodiment 1 described above in that the control device 80 further performs reference distance setting control described below.

Specifically, the control device 80 according to this embodiment performs machine learning based on a data group associating the light amount parameter of the reflected light L2 received by the optical receiver 43 with the distance between the condenser 42 and the substrate Wf in the reference distance setting control to calculate the distance between the condenser 42 and the substrate Wf such that the light amount parameter of the reflected light L2 becomes larger than the predetermined value, and uses the calculated distance as "the reference distance between the condenser 42 and the substrate Wf." The reference distance setting control will be described below with reference to the flowchart.

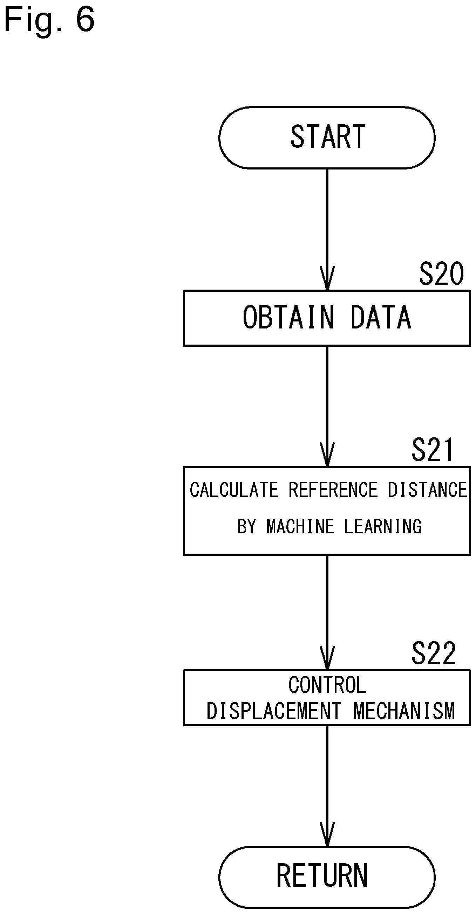

Fig. 6 is one example of the flowchart of the reference distance setting control performed by the control device 80 according to this embodiment. In Step S20, the control device 80 obtains the data group associating the light amount parameter of the reflected light L2 received by the optical receiver 43 with the distance (D) between the condenser 42 and the substrate Wf. The light amount parameter is a physical parameter related to the light amount of the reflected light L2 and the light amount or the reflectance is used as one example in this embodiment.

Each time that the polishing apparatus 100 performs polishing, the control device 80 causes the storage 82 of the control device 80 to store the above-described light amount parameter and distance (D). This allows increasing the data amount of the data group as the number of uses of the polishing apparatus 100 increases.

Next, the control device 80 performs machine learning based on the data group obtained in Step S20 to calculate the distance between the condenser 42 and the substrate Wf such that the light amount parameter of the reflected light L2 received by the optical receiver 43 becomes larger than the predetermined value and uses the calculated distance as the reference distance (Step S21). Note that Step S21 is performed before the polishing apparatus 100 starts polishing the substrate Wf.

Specifically, in Step S21, the control device 80 performs machine learning based on the data group obtained in Step S20 to calculate the correlation relationship between the light amount parameter and the distance between the condenser 42 and the substrate Wf (namely, a regression formula). The control device 80 calculates "the distance between the condenser 42 and the substrate Wf such that the light amount parameter becomes larger than the predetermined value" using the calculated correlation relationship. Then, the control device 80 uses the calculated distance as the reference distance.

As the "predetermined value" of "the distance between the condenser 42 and the substrate Wf such that the light amount parameter becomes larger than the predetermined value" described above, for example, the use of a value 90% or more of the maximum value of the light amount parameter is preferred, the use of a value 95% or more of the maximum value of the light amount parameter is more preferred, and the use of a value 98% or more of the maximum value of the light amount parameter is further preferred. In this embodiment, as the "predetermined value," the maximum value of the light amount parameter (namely, 100% of the maximum value) is used. Note that the maximum value of the light amount parameter specifically means the light amount parameter having the largest value in the data group obtained in Step S20.

That is, in Step S21, the control device 80 according to this embodiment calculates "the distance between the condenser 42 and the substrate Wf in the data group obtained in Step S20 such that the light amount parameter becomes the maximum" and uses the calculated distance as the reference distance. Note that it is considered that when the distance between the condenser 42 and the substrate Wf matches the focal point distance of the condenser 42, the light amount parameter becomes the maximum.

After Step S21 described above, the control device 80 performs Step S22. Step S22 is also performed before the polishing apparatus 100 starts polishing the substrate Wf. In Step S22, the control device 80 controls the displacement mechanism 60 such that the distance between the condenser 42 and the substrate Wf becomes the reference distance calculated in Step S21.

Thus, according to this embodiment, the distance between the condenser 42 and the substrate Wf can be set such that the light amount parameter of the reflected light L2 becomes larger than the predetermined value without manpower. Specifically, according to this embodiment, the distance between the condenser 42 and the substrate Wf can be a distance such that the light amount parameter of the reflected light L2 becomes the maximum without manpower.

### (Embodiment 3)

Subsequently, Embodiment 3 of the present invention will be described. The polishing apparatus 100 according to this embodiment differs from Embodiment 1 and Embodiment 2 described above in that the control device 80 further performs abnormality determination control described below.

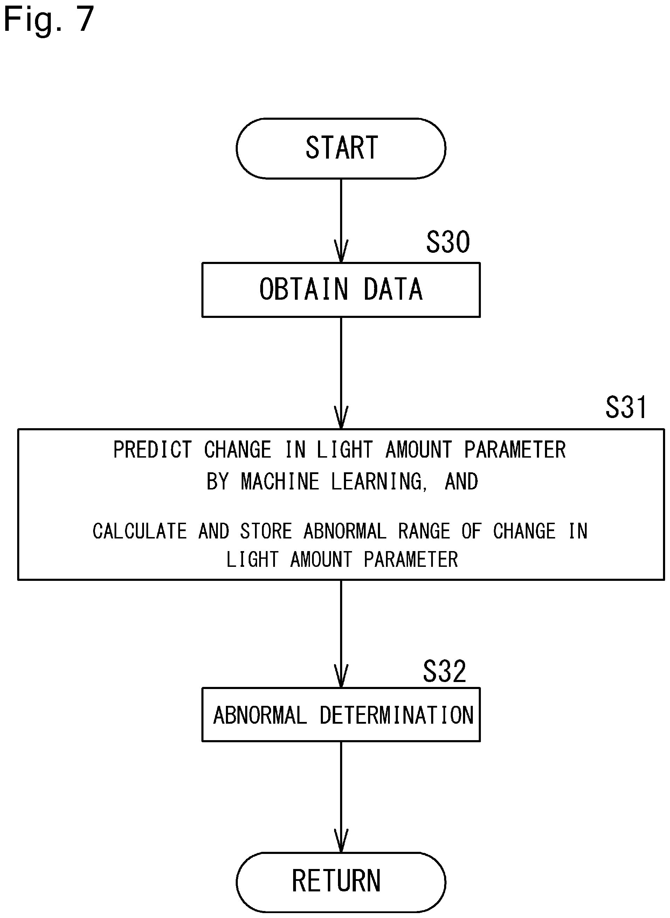

Fig. 7 is one example of a flowchart of the abnormality determination control performed by the control device 80 according to this embodiment. In Step S30, the control device 80 obtains the data group associating a "process condition" as a condition related to a polishing speed of the substrate Wf by the polishing apparatus 100 (polishing rate) with the light amount parameter of the reflected light L2 received by the optical receiver 43.

Although the process condition is not specifically limited as long as it is a condition related to the polishing rate, for example, a condition including at least one of the type of the substrate Wf, a polishing load (N) as a load for pressing the substrate Wf against the polishing pad 90, a rotation speed (rpm) of the polishing table 11, a rotation speed (rpm) of the substrate holding member 12, the type of the slurry supplied to the polishing pad 90, polishing time (sec) of the substrate Wf, and the type of the polishing pad 90 can be used. As one example, the process condition according to this embodiment includes all of the matters.

Note that as the type of the substrate Wf, for example, information, such as the material of the surface to be polished Wfc of the substrate Wf and the shape of the surface to be polished Wfc of the substrate Wf can be used. As the type of the slurry, for example, information, such as the material of the slurry and the concentration of the slurry, can be used. As the type of the polishing pad 90, for example, information, such as the material of the polishing surface 91 of the polishing pad 90 and the surface roughness of the polishing surface 91, can be used.

Additionally, each time the polishing apparatus 100 performs polishing, the control device 80 causes the storage 82 of the control device 80 to store the above-described process condition and light amount parameter. Thus, as the number of uses of the polishing apparatus 100 increases, the data amount of the data group can be increased.

Subsequent to Step S30, the control device 80 performs Step S31. In Step S31, the control device 80 performs machine learning based on the data group obtained in Step S30 to predict "the change in light amount parameter" as the change in the light amount parameter of the reflected light L2 in association with a lapse of the polishing time corresponding to the process condition. Then, the control device 80 calculates the range of the change in light amount parameter equivalent to a case where abnormality occurs in the polishing apparatus 100 based on the predicted change in light amount parameter (namely, an abnormal range of the change in light amount parameter) and causes the storage 82 (storage medium) to store the calculated abnormal range of the change in light amount parameter. Note that Step S31 is performed before the polishing apparatus 100 starts polishing the substrate Wf.

Here, when the process condition (the condition related to the polishing rate) differs, as a result of difference in decrease speed of the thickness of the substrate Wf (film thickness) in association with a lapse of the polishing time, the change in light amount parameter also has a different aspect. Accordingly, a correlation relationship is recognized between the process condition and the change in light amount parameter. Based on the knowledge, the control device 80 according to this embodiment predicts the change in light amount parameter through machine learning based on the data group associating the process condition with the light amount parameter as in Step S31 described above. Additionally, in this embodiment, "abnormality occurs in the polishing apparatus 100" specifically means that the polishing rate of the substrate Wf by the polishing apparatus 100 is outside the normal speed range.

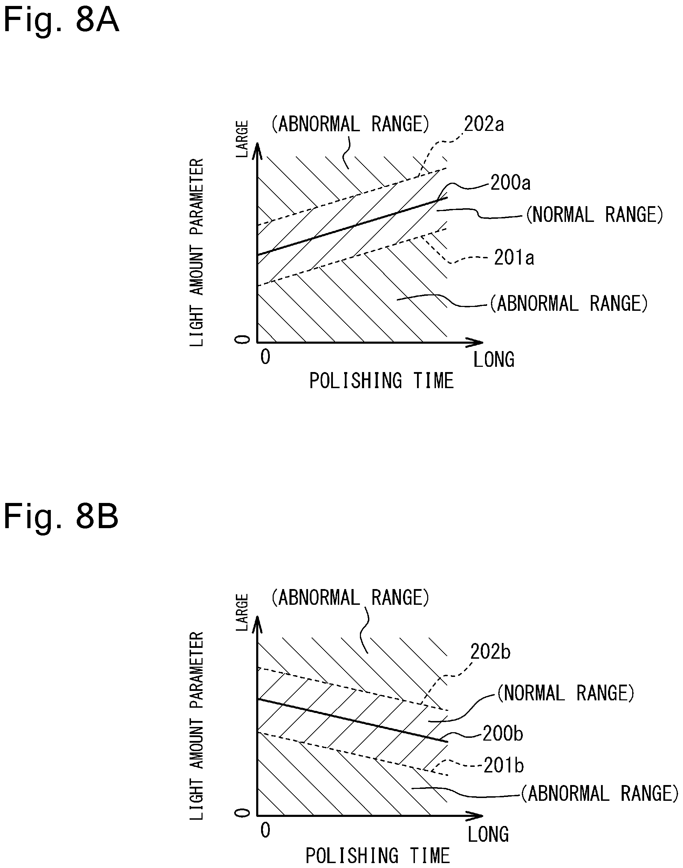

The following will describe the control process according to Step S31 described above with reference to the drawings. Fig. 8A and Fig. 8B are schematic diagrams for describing the control process according to Step S31. Specifically, Fig. 8A schematically illustrates the state of the change in light amount parameter when the process condition is a predetermined condition (referred to as a "condition A"). Meanwhile, Fig. 8B schematically illustrates the state of the change in light amount parameter when the process condition is a "condition B" different from the condition A. Note that Fig. 8A and Fig. 8B plot the light amount parameter (the light amount or the reflectance as one example in this embodiment) in the vertical axis and the polishing time in the horizontal axis.

A line 200a in Fig. 8A is a line schematically illustrating the change in light amount parameter predicted in Step S31 when the process condition is the condition A. A range partitioned by a line 201a and a line 202a (a range equal to or more than the light amount parameter of the line 201a and equal to or less than the light amount parameter of the line 202a) is a range of the change in light amount parameter equivalent to the case where the polishing apparatus 100 is normal ("the normal range of the change in light amount parameter"). Then, the range where the light amount parameter is smaller than the line 201a and the range where the light amount parameter is larger than the line 202a are the range of the change in light amount parameter equivalent to the case where abnormality occurs in the polishing apparatus 100 ("the abnormal range of the change in light amount parameter").

The control device 80 subtracts the predetermined value from the change in light amount parameter of the line 200a to obtain the change in light amount parameter of the line 201a, and adds the predetermined value to the change in light amount parameter of the line 200a to obtain the change in light amount parameter of the line 202a. Then, the control device 80 calculates the range where the change in light amount parameter is smaller than the line 201a and the range where the change in light amount parameter is larger than the line 202a as "the abnormal range of the change in light amount parameter corresponding the condition A" and causes the storage 82 to store it.

A line 200b in Fig. 8B is a line schematically illustrating the change in light amount parameter predicted in Step S31 when the process condition is the condition B. The range partitioned by a line 201b and a line 202b (the range equal to or more than the light amount parameter of the line 201b and the range equal to or less than the light amount parameter of the line 202b) is the change in light amount parameter equivalent to the case where the polishing apparatus 100 is normal ("the normal range of the change in light amount parameter"). Then, the range where the light amount parameter is smaller than the line 201b and the range where the light amount parameter is larger than the line 202b is the range of the change in light amount parameter equivalent to the case where abnormality occurs in the polishing apparatus 100 ("the abnormal range of the change in light amount parameter").

The control device 80 subtracts the predetermined value from the change in light amount parameter of the line 200b to obtain the change in light amount parameter of the line 201b, and adds the predetermined value to the change in light amount parameter of the line 200b to obtain the change in light amount parameter of the line 202b. The control device 80 calculates the range where the change in light amount parameter is smaller than the line 201b and the range where the change in light amount parameter is larger than the line 202b as "the abnormal range of the change in light amount parameter corresponding to the condition B" as and causes the storage 82 to store it.

Step S31 in Fig. 7 is performed as described above. After Step S31, the control device 80 performs Step S32. Step S32 is performed during polishing the substrate Wf by the polishing apparatus 100. In Step S32, the control device 80 determines whether abnormality occurs in the polishing apparatus 100 based on the abnormal range of the change in light amount parameter stored in Step S31 and the actually measured value of the change in light amount parameter measured using the sensor 30 (the actually measured value of the change in light amount parameter measured based on the reflected light L2 received by the optical receiver 43). Specifically, the control device 80 determines whether the actually measured value of the change in light amount parameter measured during polishing is within the abnormal range of the change in light amount parameter stored in the storage 82 to determine whether abnormality occurs in the polishing apparatus 100.

For example, when the process condition of polishing by the polishing apparatus 100 is the condition A, in Step S32, when the actually measured value of the change in light amount parameter is within the abnormal range of Fig. 8A, the control device 80 determines that some sort of abnormality occurs in the polishing apparatus 100. Meanwhile, when the actually measured value of the change in light amount parameter is outside the abnormal range of Fig. 8A, (within the normal range), the control device 80 determines that abnormality does not occur (normal) in the polishing apparatus 100.

For example, when the process condition of polishing by the polishing apparatus 100 is the condition B, in a case where the actually measured value of the change in light amount parameter is within the abnormal range of Fig. 8B, the control device 80 determines that some sort of abnormality occurs in the polishing apparatus 100, and in a case where the actually measured value is outside the abnormal range of Fig. 8B (within the normal range), the control device 80 determines that abnormality does not occur (normal) in the polishing apparatus 100.

According to this embodiment described above, whether abnormality occurs in the polishing apparatus 100 can be determined.

Note that the control device 80 causes the storage 82 of the control device 80 to store the determination result of abnormality determination. Additionally, the polishing apparatus 100 may include a notification device (not illustrated) that notifies a user of the polishing apparatus 100 of predetermined information. In this case, the control device 80 may notify the notification device of the determination result of abnormality determination. As the notification device, a lamp, a buzzer, a display, a combination of them, and the like can be used.

### (Embodiment 4)

Subsequently, Embodiment 4 of the present invention will be described. The polishing apparatus 100 according to this embodiment differs from Embodiment 1, Embodiment 2, and Embodiment 3 described above in that substrate slip-out determination control described below is further performed.

Specifically, in the substrate slip-out determination control, the control device 80 according to this embodiment determines whether the "substrate slip-out" in which the substrate Wf comes off from the substrate holding member 12 occurs based on whether the light amount parameter of the reflected light L2 received by the optical receiver 43 is smaller than a preliminarily set threshold.

When the substrate Wf is held onto the substrate holding member 12, the light amount parameter of the reflected light L2 has a value at least equal to or more than the threshold. However, when substrate slip-out occurs, the light amount parameter of the reflected light L2 becomes smaller than the threshold. Using the property, the control device 80 determines presence/absence of substrate slip-out through comparison between the light amount parameter of the reflected light L2 and the threshold. The substrate slip-out control will be described below with reference to the flowchart.

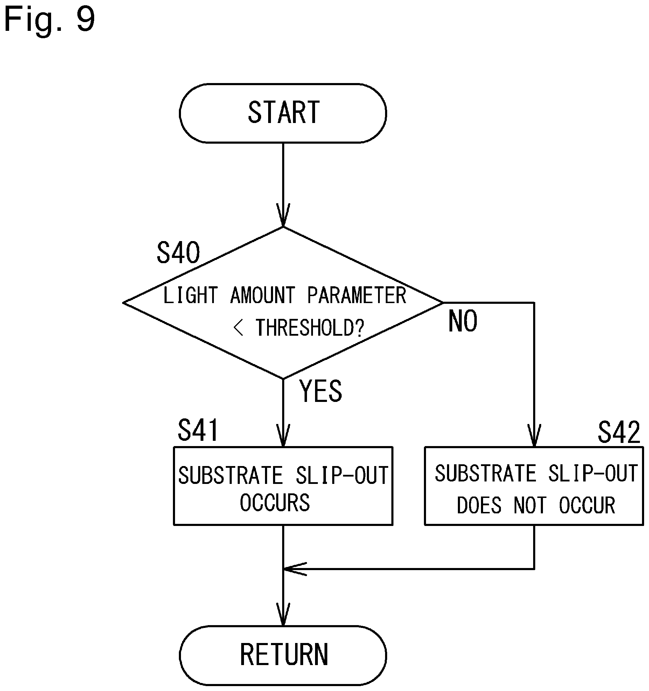

Fig. 9 is one example of the flowchart of the substrate slip-out control performed by the control device 80 according to this embodiment. The control device 80 performs the flowchart of Fig. 9 during polishing the substrate Wf by the polishing apparatus 100. In Step S40, the control device 80 determines whether the light amount parameter of the reflected light L2 received by the optical receiver 43 (the actually measured value of the light amount parameter) is smaller than the preliminarily set threshold. It is only necessary to obtain an appropriate value of the threshold by experiment, simulation, or the like in advance and store it in the storage 82 of the control device 80.

When Step S40 is determined to be YES (that is, when the light amount parameter of the reflected light L2 is smaller than the threshold), the control device 80 determines that substrate slip-out occurs (Step S41). On the other hand, when Step S40 is determined to be NO, the control device 80 determines that substrate slip-out does not occur (Step S42).

According to this embodiment described above, whether substrate slip-out occurs can be determined.

Note that the control device 80 causes the storage 82 of the control device 80 to store the determination result of substrate slip-out. Additionally, when the polishing apparatus 100 includes the above-described notification device, the control device 80 may notify the notification device of the determination result of substrate slip-out.

Although the embodiments of the present invention have been described in detail above, the present invention is not limited to the specific embodiments. Various changes and modifications can be made without departing from the scope of the gist of the present invention as defined in the appended claims.

### REFERENCE SIGNS LIST

- 11: polishing table
- 12: substrate holding member
- 40: sensor head
- 41: projector
- 42: condenser
- 43: optical receiver
- 60: displacement mechanism
- 70: abrade amount measurement device
- 80: control device
- 82: storage (storage medium)
- 90: polishing pad
- 91: polishing surface
- 92: light transmitting member
- 100: polishing apparatus
- L1: incident light
- L2: reflected light
- Wf: substrate

## Claims

1. A polishing apparatus comprising:
a substrate holding member configured to hold a substrate; and
a polishing table configured to hold a polishing pad, wherein
the polishing apparatus is configured to polish the substrate while pressing the substrate against the polishing pad, and
the polishing apparatus comprises:
a sensor head that includes a projector, a condenser, and an optical receiver, the projector being configured to project incident light, the condenser being configured to condense the incident light projected from the projector and cause the incident light to be incident on the substrate, the optical receiver being configured to receive reflected light reflected by the substrate;
a displacement mechanism configured to relatively displace the condenser with respect to the substrate to change a distance between the condenser and the substrate;
an abrade amount measurement device configured to measure an abrade amount of the polishing pad; and
a control device, wherein
the control device is configured to measure a polishing state of the substrate based on a light amount parameter, the light amount parameter is a parameter related to a light amount of the reflected light received by the optical receiver, and the control device is configured to control the displacement mechanism based on the abrade amount of the polishing pad measured by the abrade amount measurement device such that the distance between the condenser and the substrate is maintained at a preliminarily set reference distance.

2. The polishing apparatus according to claim 1, wherein
the control device is configured to measure a polishing ending point of the substrate as the polishing state of the substrate.

3. The polishing apparatus according to claim 1 or 2, wherein
the control device is configured to further calculate a distance between the condenser and the substrate such that the light amount parameter becomes larger than a predetermined value by performing machine learning based on a data group associating the light amount parameter with the distance between the condenser and the substrate, and use the distance as the reference distance.

4. The polishing apparatus according to any one of claims 1 to 3, wherein
the control device is configured to further predict a change in light amount parameter, which is a change in the light amount parameter in association with a lapse of a polishing time, corresponding a process condition related to a polishing rate of the substrate by the polishing apparatus, by performing machine learning based on a data group associating the process condition with the light amount parameter, and
the control device is configured to calculate an abnormal range of the change in light amount parameter equivalent to a case where abnormality occurs in the polishing apparatus based on the predicted change in light amount parameter and cause a storage medium to store the calculated abnormal range of the change in light amount parameter.

5. The polishing apparatus according to claim 4, wherein
the control device is configured to further determine whether abnormality occurs in the polishing apparatus based on the abnormal range of the change in light amount parameter stored in the storage medium and an actually measured value of the change in light amount parameter during polishing the substrate by the polishing apparatus.

6. The polishing apparatus according to any one of claims 1 to 5, wherein
the control device is configured to further determine whether substrate slip-out in which the substrate comes off from the substrate holding member occurs based on whether the light amount parameter is smaller than a threshold.

7. The polishing apparatus according to any one of claims 1 to 6, wherein
the sensor head is disposed on the polishing table, and the sensor head is configured to rotate together with the polishing table during polishing the substrate by the polishing apparatus, and
the control device is configured such that when a relative position between the substrate and the sensor head is at a position where the incident light is incident on a surface to be polished during polishing the substrate by the polishing apparatus, the control device further controls projection timing of the projector such that the projector projects the incident light.

8. The polishing apparatus according to claim 7, wherein
a light transmitting member configured to transmit the incident light condensed by the condenser and the reflected light reflected by the substrate is disposed on a part of the polishing pad.

9. A polishing method comprising:
a step of condensing incident light projected from a projector during polishing a substrate by a polishing apparatus by a condenser to cause the incident light to be incident on the substrate, receiving reflected light reflected by the substrate by an optical receiver, and measuring a polishing state of the substrate based on a light amount parameter as a parameter related to a light amount of the reflected light received by the optical receiver; and
a step of relatively displacing the condenser with respect to the substrate based on an abrade amount of a polishing pad against which the substrate is pressed such that a distance between the condenser and the substrate is maintained at a preliminarily set reference distance during polishing the substrate by the polishing apparatus.
